# EUROPEAN PATENT APPLICATION

(11) **EP 4 694 098 A1**
(43) Date of publication of application: **11.02.2026**
(21) Application number: 24815779.4
(22) Date of filing: 23.05.2024
(51) Int. Cl.: H04M 1/02, H04M 1/18, H01Q 1/24, G06F 1/16

(54) **ELECTRONIC DEVICE INCLUDING MOLDING PART**

(30) Priority: 02.06.2023 KR 20230071704; 18.07.2023 KR 20230092944
(71) Applicant: Samsung Electronics Co., Ltd., Suwon-si, Gyeonggi-do 16677 (KR)
(72) Inventor: PARK, Jungsik, Suwon-si, Gyeonggi-do 16677 (KR); LEE, Sunghyup, Suwon-si, Gyeonggi-do 16677 (KR)
(74) Representative: Gulde & Partner
(86) International application number: PCT/KR2024/006977
(87) International publication number: WO 2024/248402

(57) **Abstract**

An electronic device according to an embodiment of the present disclosure may include a housing, a display including a bending area disposed at a distal end of the display and extending while being bent, the display having at least a part surrounded by the housing, a window cover disposed in one direction of the display, a plate including an extension area extending and spaced apart from the bending area of the display, the plate having at least a part disposed in the other direction that is a direction opposite to one direction of the display, and a molded part disposed in a space surrounded by the bending area of the display, the window cover, and the extension area of the plate.

## Description

### [Technical Field]

The present disclosure relates to an electronic device including a molded part.

### [Background Art]

An electronic device may include a bending area of a display, a window cover configured to surround the bending area of the display, and a housing. The bending area of the display may be an area in which the display extends while being bent in a chip-on-panel (COP) section positioned at a distal end of the display.

The electronic device may include waterproof and dustproof structures provided in a space between the bending area of the display, the window cover, and the housing. For example, in the electronic device, a molded part is disposed on a part of the bending area of the display and a part of the window cover, and a bonding member is attached to a lower portion of the molded part, which may prevent or reduce the inflow of water and dust into the electronic device. The molded part may be attached to the housing by means of the bonding member attached to the lower portion of the molded part.

The electronic device may include a black masking (BM) area. The BM area may include a bonding structure for waterproofness and dustproofness and intervals defined between the display and peripheral mechanisms in consideration of a dead space (DS), which is an outer peripheral wiring space of the display, manufacturing tolerance, and absorption of external impact.

### [Disclosure of Invention]

### [Solution to Problem]

In case that a thickness of the molded part increases to absorb an impact applied to the bending area of the display, an overall thickness of the electronic device may increase.

The black masking (BM) area of the electronic device may increase a width of an electronic device set, decrease an active area (AA) area of the display, in which images are displayed, and increase an unnecessary space in the electronic device.

In case that the bonding member is attached directly to the lower portion of the molded part, the molded part may be damaged by a bonding force of the bonding member during a process of reassembling the electronic device (e.g., a reassembling process performed because of erroneous attachment).

An electronic device according to an example embodiment of the present disclosure may include: a housing, a display including a bending area disposed at a distal end of the display and extending and being bent, at least a part of the display being surrounded by the housing, a window cover disposed in one direction of the display, a plate including an extension area extending and spaced apart from the bending area of the display, the plate having at least a part disposed in an other direction opposite to one direction of the display, and a molded part disposed in a space surrounded by the bending area of the display, the window cover, and the extension area of the plate.

An electronic device according to an example embodiment of the present disclosure may include: a housing, a display including a bending area disposed at a distal end of the display and extending and being bent, at least a part of the display being surrounded by the housing, a window cover disposed in one direction of the display, a plate including an extension area extending and spaced apart from the bending area of the display, the plate having at least a part disposed in an other direction opposite to one direction of the display, and a molded part disposed in a space surrounded by the bending area of the display, the window cover, and the extension area of the plate, wherein the extension area includes: a first distal end area having at least a part extending and being bent to surround an outer periphery of the bending area of the display, and a second distal end area extending in a direction parallel to a longitudinal direction of the electronic device, and in which the first distal end area and the second distal end area are formed alternately in a width direction of the electronic device.

In the electronic device according to an example embodiment of the present disclosure, the plate may be disposed on a part of the molded part, which may protect the bending area of the display from an external impact.

In the electronic device according to an example embodiment of the present disclosure, the plate is disposed on a part of the molded part, such that the thickness of the molded part is relatively small, which may reduce the overall thickness of the electronic device.

In the electronic device according to an example embodiment of the present disclosure, the molded part is disposed in the bending area of the display, which may reduce the BM area of the electronic device.

In the electronic device according to an example embodiment of the present disclosure, a part of the housing, which faces the bending area of the display, is formed concavely, which may reduce the BM area of the electronic device.

In the electronic device according to an example embodiment of the present disclosure, a bonding member comprising a bonding material is attached to the plate, which may prevent or reduce damage to the molded part during the process of reassembling the electronic device.

### [Brief Description of Drawings]

FIG. 1 is a block diagram of an electronic device in a network environment according to an embodiment.
FIGS. 2A and 2B are perspective views of the electronic device according to the embodiments of the present disclosure.
FIG. 3 is a deployed perspective view of the electronic device according to the embodiment of the present disclosure.
FIG. 4 is a view illustrating the electronic device according to the embodiment of the present disclosure.
FIGS. 5A and 5B are partial cross-sectional views illustrating a plate and a molded part according to various embodiments;
FIGS. 6A and 6B are partial cross-sectional views illustrating an injection-molded part and the molded part according to various embodiments;
FIGS. 7A, 7B, 7C, and 7D are partial cross-sectional views illustrating the plate and the molded part according to various embodiments;
FIG. 8 is a partial cross-sectional view illustrating a bonding member according to various embodiments;
FIGS. 9A and 9B are partial cross-sectional views illustrating a state in which the molded part, a display, and the plate are coupled according to various embodiments;
FIG. 10 is a partial cross-sectional view illustrating the molded part according to various embodiments;
FIGS. 11A and 11B are partial cross-sectional views illustrating a state in which the molded part and the display are coupled according to various embodiments;
FIG. 12 is a partial perspective view illustrating the electronic device according to various embodiments;
FIGS. 13A, 13B, and 13C are partial perspective views illustrating the plate, the display, and a window cover according to various embodiments; and
FIG. 14 is a partial exploded perspective view illustrating the electronic device including a housing according to the embodiment of the present disclosure.

### [Mode for the Invention]

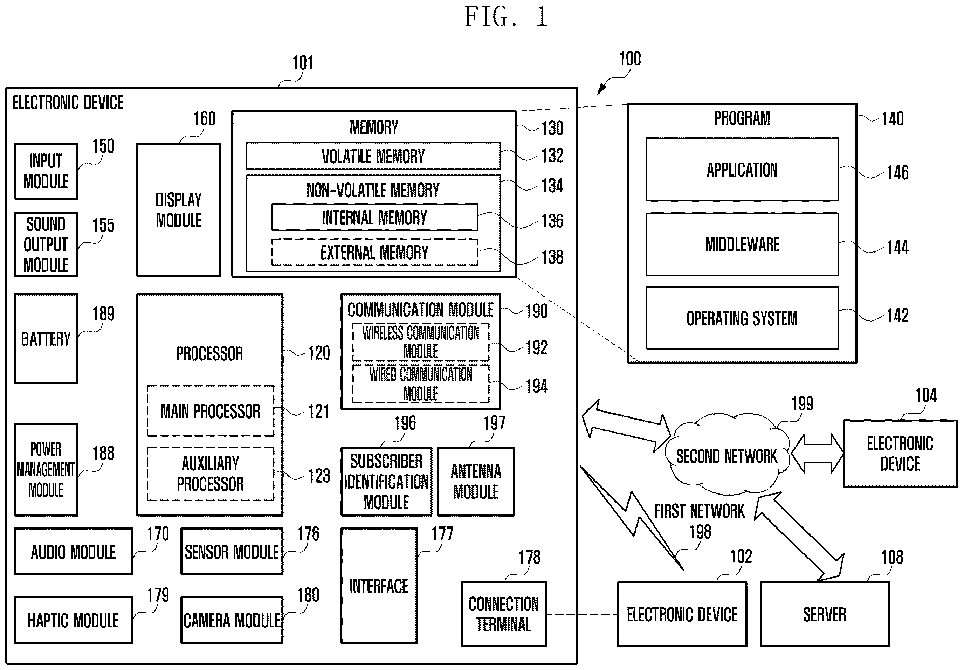

FIG. 1 is a block diagram illustrating an example electronic device in a network environment according to an embodiment. Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited/disclosed functions, e.g., in a distributed manner. At least one processor may execute program instructions to achieve or perform various functions. The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter(mm) Wave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

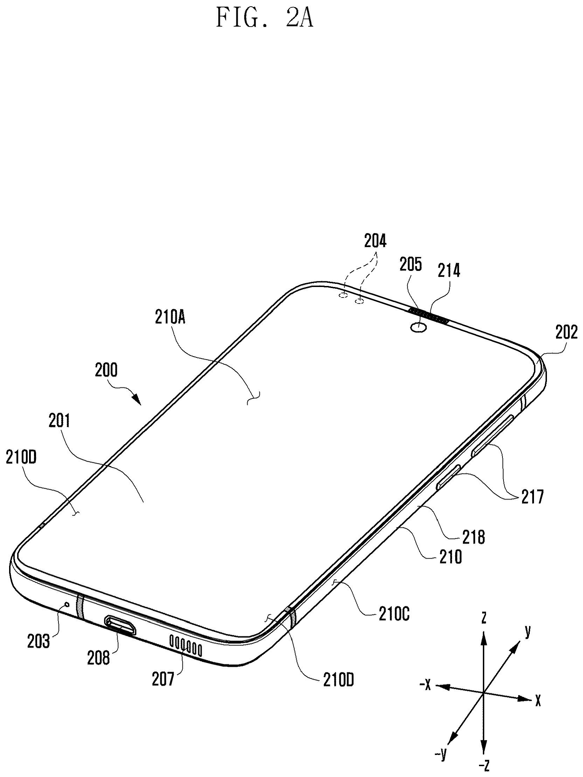

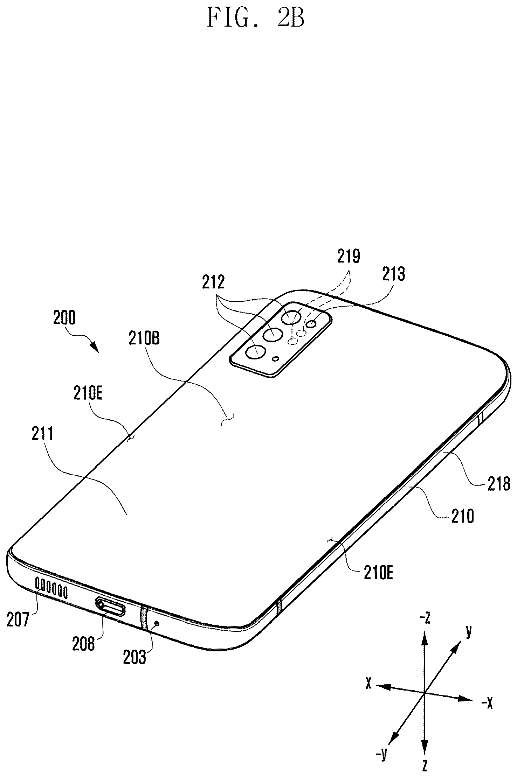

FIG. 2A is a front perspective view of an electronic device 200 according to various embodiments. FIG. 2B is a rear perspective view of electronic device 200 of FIG. 2A according to various embodiments.

The electronic device 200 in FIGS. 2A and 2B may be at least partially similar to the electronic device 101 in FIG. 1 or may further include various embodiments.

Referring to FIGS. 2A and 2B, the mobile electronic device 200 may include a housing 210 that includes a first surface (or front surface) 210A, a second surface (or rear surface) 210B, and a lateral surface 210C that surrounds a space between the first surface 210A and the second surface 210B. The housing 210 may refer to a structure that forms a part of the first surface 210A, the second surface 210B, and the lateral surface 210C. The first surface 210A may be formed of a front plate 202 (e.g., a glass plate or polymer plate coated with a variety of coating layers) at least a part of which is substantially transparent. The second surface 210B may be formed of a rear plate 211 which is substantially opaque. The rear plate 211 may be formed of, for example, coated or colored glass, ceramic, polymer, metal (e.g., aluminum, stainless steel (STS), or magnesium), or any combination thereof. The lateral surface 210C may be formed of a lateral bezel structure (or "lateral member") 218 which is combined with the front plate 202 and the rear plate 211 and includes a metal and/or polymer. The rear plate 211 and the lateral bezel structure 218 may be integrally formed and may be of the same material (e.g., a metallic material such as aluminum).

The front plate 202 may include two first regions 210D disposed at long edges thereof, respectively, and bent and extended seamlessly from the first surface 210A toward the rear plate 211. Similarly, the rear plate 211 may include two second regions 210E disposed at long edges thereof, respectively, and bent and extended seamlessly from the second surface 210B toward the front plate 202. The front plate 202 (or the rear plate 211) may include only one of the first regions 210D (or of the second regions 210E). The first regions 210D or the second regions 210E may be omitted in part. When viewed from a lateral side of the mobile electronic device 200, the lateral bezel structure 218 may have a first thickness (or width) on a lateral side where the first region 210D or the second region 210E is not included, and may have a second thickness, being less than the first thickness, on another lateral side where the first region 210D or the second region 210E is included.

According to an embodiment, the electronic device 200 may include at least one of a display 201, an input device 203, audio modules 207 and 214, sensor modules 204 and 219, camera modules 205, 212 and 213, a key input device 217, an indicator, and a connector 208. The mobile electronic device 200 may omit at least one (e.g., the key input device 217 or the indicator) of the above components, or may further include other components.

The display 201 may be visible through a substantial portion of the front plate 202, for example. At least a part of the display 201 may be visible through the front plate 202 that forms the first surface 210A and the first region 210D of the lateral surface 210C. The display 201 may be combined with, or adjacent to, a touch sensing circuit, a pressure sensor capable of measuring the touch strength (pressure), and/or a digitizer for detecting a stylus pen. At least a part of the sensor modules 204 and 219 and/or at least a part of the key input device 217 may be disposed in the first region 210D and/or the second region 210E.

The input device 203 may include at least one microphone. In certain embodiments, the input device 203 may include a plurality of microphones disposed to detect the direction of a sound. According to an embodiment, the sound output devices 207 and 214 may include speakers. Speakers may include an external speaker 207 and a call receiver 214. In certain embodiments, the input device 203, the sound output devices 207 and 214, and the connector 208 may be disposed in a space arranged in the housing 210 of the electronic device 200, and may be exposed to the external environment through at least one hole formed in the housing 210. In certain embodiments, the sound output devices 207 and 214 may include a speaker (e.g., piezo speaker) that operates without using a hole formed in the housing 210.

The sensor modules 204 and 219 may generate electrical signals or data corresponding to an internal operating state of the mobile electronic device 200 or to an external environmental condition. The sensor modules 204 and 219 may include a first sensor module 204 (e.g., a proximity sensor) and/or a second sensor module (e.g., a fingerprint sensor) disposed on the first surface 210A of the housing 210, and/or a third sensor module 219 (e.g., a heart rate monitor (HRM) sensor) and/or a fourth sensor module (e.g., a fingerprint sensor) disposed on the second surface 210B of the housing 210. The fingerprint sensor may be disposed on the second surface 210B as well as the first surface 210A (e.g., the display 201) of the housing 210. The electronic device 200 may further include at least one of a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212 and 213 may include a first camera device 205 disposed on the first surface 210A of the electronic device 200, and a second camera device 212 and/or a flash 213 disposed on the second surface 210B. The camera module 205 or the camera module 212 may include one or more lenses, an image sensor, and/or an image signal processor. The flash 213 may include, for example, a light emitting diode or a xenon lamp. Two or more lenses (infrared cameras, wide angle and telephoto lenses) and image sensors may be disposed on one side of the electronic device 200.

The key input device 217 may be disposed on the lateral surface 210C of the housing 210. The mobile electronic device 200 may not include some or all of the key input device 217 described above, and the key input device 217 which is not included may be implemented in another form such as a soft key on the display 201. According to an embodiment, the key input device 217 may be implemented using a pressure sensor included in the display 201.

The indicator may be disposed on the first surface 210A of the housing 210. For example, the indicator may provide status information of the electronic device 200 in an optical form. The indicator may provide a light source associated with the operation of the camera module 205. The indicator may include, for example, a light emitting diode (LED), an IR LED, or a xenon lamp.

The connector holes 208 may include a first connector hole 208 adapted for a connector (e.g., a USB connector) for transmitting and receiving power and/or data to and from an external electronic device, and/or a second connector hole adapted for a connector (e.g., an earphone jack) for transmitting and receiving an audio signal to and from an external electronic device.

Some camera modules 205 of camera modules 205 and 212, some sensor modules 204 of sensor modules 204 and 219, or an indicator may be arranged to be exposed through a display 201. For example, the camera module 205, the sensor module 204, or the indicator may be arranged in the internal space of an electronic device 200 so as to be brought into contact with an external environment through an opening of the display 201, which is perforated up to a front plate 202. According to an embodiment, an area corresponding to some camera module 205 of the display 201 is a part of an area in which content is displayed, and may be formed as a transmission area having designated transmittance. For example, the transmission area may be formed to have transmittance having a range of about 5% to about 20%. The transmission area may include an area overlapped with a valid area (e.g., a field of view (FOV)) of the camera module 205 through which light imaged by an image sensor and for generating an image passes. For example, a transmission area of the display 201 may include an area in which the density of pixels and/or a wiring density are lower than that of surroundings. The camera module 205 may include, for example, under display camera (UDC). In an embodiment, some sensor modules 204 may be arranged to perform their functions without being visually exposed through the front plate 202 in the internal space of the electronic device. For example, in this case, an area of the display 201 facing the sensor module may not require a perforated opening.

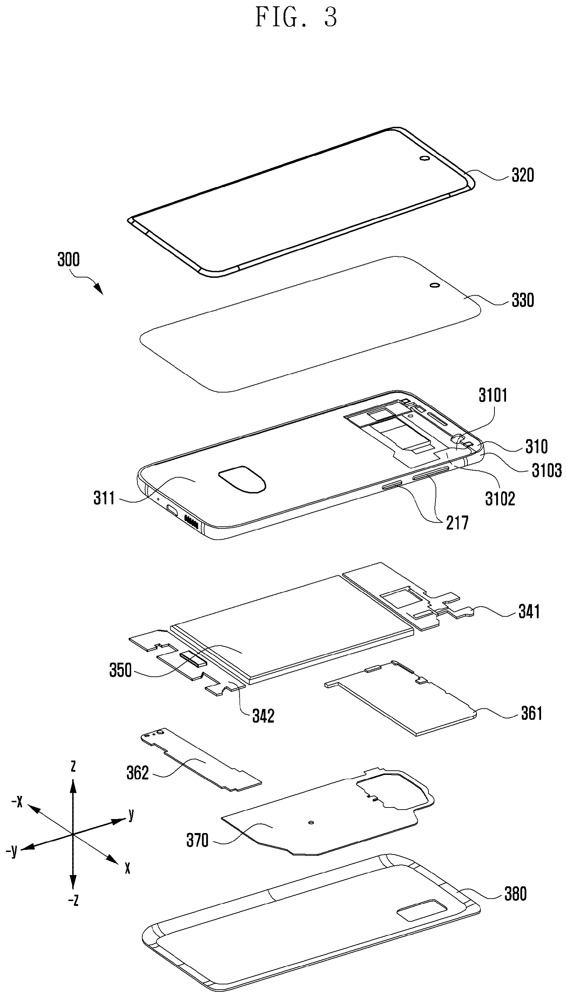

FIG. 3 is an exploded perspective view of the electronic device 300 according to various embodiments.

An electronic device 300 in FIG. 3 may be at least partially similar to the electronic device 101 in FIG. 1 and/or electronic device 200 in FIG. 2A, or may include an embodiment of the electronic device.

Referring to FIG. 3, the electronic device 300 (e.g., the electronic device 101 in FIG. 1 or the electronic device 200 in FIG. 2A) may include a lateral member 310 (e.g., a lateral bezel structure 218 in FIG. 2A), a first support member 311 (e.g., a bracket or a support structure), a front plate 320 (e.g., a front plate 202 in FIG. 2A), a display 330 (e.g., the display 201 in FIG. 2A), a substrate 341 and 342 (e.g., a printed circuit board (PCB), a flexible PCB (FPCB), or a rigid-flexible PCB (RFPCB)), a battery 350, a second support member 361 and 362 (e.g., a rear case), an antenna 370, and a rear cover 380 (e.g., a rear plate 211 in FIG. 2B). In various embodiments, at least one (e.g., the first support member 311 or the second support member 361 and 362) of the elements may be omitted from the electronic device 300, or other elements may be additionally included therein. At least one of elements of the electronic device 300 may be the same as or similar to at least one of elements of the electronic device 101 in FIG. 1 Or the electronic device 200 in FIG. 2A, and overlapping descriptions thereof will be omitted hereinafter.

According to an embodiment, the lateral member 310 has a first surface 3101 facing in a first direction (e.g., z-axis direction), a second surface 3102 facing in a direction opposite to the first surface 3101, and a side surface 3103 surrounding the space between the first surface 3101 and the second surface 3102. According to an embodiment, at least a portion of the side surface 3103 may form the exterior of the electronic device. According to an embodiment, the support member 311 may be arranged to extend from the lateral member 310 toward the internal space of the electronic device 300. In various embodiments, support member 311 may be disposed separately from lateral member 310. According to an embodiment, for example, the lateral member 310 and/or the support member 311 may be formed of a metal material and/or a non-metal (e.g., polymer) material. According to an embodiment, the support member 311 may support at least a portion of the display 330 through the first surface 3101 and supports at least one substrate 341 and 342 through the second surface 3102 and/or may be arranged to support at least a portion of the battery 350. According to an embodiment, the at least one substrate 341 and 342 is a first substrate 341 (e.g., main substrate) disposed on one side with respect to the battery 350 and a second substrate 342 (e.g., sub substrate) disposed on the other side, in the internal space of the electronic device 300. According to an embodiment, the first substrate 341 and/or the second substrate 342 may include a processor, memory, and/or an interface. For example, the processor may include one or more of a central processing device, an application processor, a graphic processing device, an image signal processor, a sensor hub processor, and a communication processor. For example, the memory may include a volatile memory or a non-volatile memory. For example, the interface may include a high definition multimedia interface (HDMI), a universal serial bus (USB) interface, an SD card interface, and/or an audio interface. For example, the interface may electrically or physically connect the electronic device 300 to an external electronic device, and may include a USB connector, an SD card/MMC connector, or an audio connector. The battery 350 may be a device for supplying power to at least one element of the electronic device 300, and for example, may include a non-rechargeable primary cell, a rechargeable secondary cell, or a fuel cell. For example, at least a part of the battery 350 may be disposed on substantially the same plane as the substrate 341 and 342. The battery 350 may be integrally disposed inside the electronic device 300. As an embodiment, the battery 350 may also be disposed detachably from the electronic device 300.

The antenna 370 may be disposed between the rear cover 380 and the battery 350. For example, the antenna 370 may also include a near field communication (NFC) antenna, a wireless charging antenna, and/or a magnetic secure transmission (MST) antenna. For example, the antenna 370 may be configured to perform a short-range communication with an external device, or may wirelessly transmit/receive a power required for charging. In an embodiment, an antenna structure may be formed by a part of the lateral bezel structure 310 and/or the first support member 311, or a combination thereof. In various embodiments, the electronic device 300 may further include a digitizer for detecting an external electronic pen.

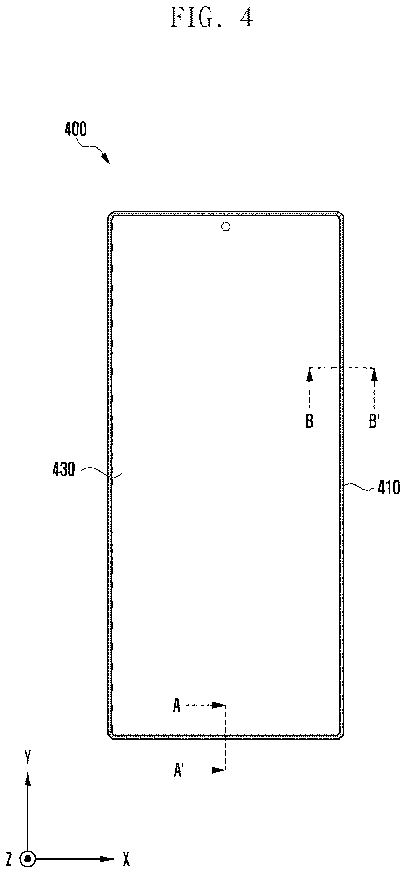

FIG. 4 is a diagram illustrating an electronic device 400 according to various embodiments.

The electronic device 400 illustrated in FIG. 4 may refer, for example, ot the electronic device 101 in FIG. 1 or include at least a part of the electronic device 101 in FIG. 1.

The electronic device 300 illustrated in FIG. 4 may refer, for example, to the electronic devices 200 and 300 in FIGS. 2A and 3 or include at least a part of the electronic devices 200 and 300 in FIGS. 2A and 3.

In the description of the electronic device 400 according to an embodiment of the present disclosure, a width direction of the electronic device 400 may refer, for example, to an X-axis direction, and a longitudinal direction of the electronic device 400 may refer, for example, to a Y-axis direction. A height direction of the electronic device 400 may refer, for example, to a Z-axis direction.

In an embodiment, the electronic device 400 may include a housing 410 and/or a window cover 430.

In an embodiment, the housing 410 may define an external appearance of the electronic device 400 and provide a space in which components of the electronic device 400 are disposed. The components of the electronic device 400 may be disposed in the housing 410. The housing 410 may be substantially identical in configuration to the housing 210 in FIG. 2A.

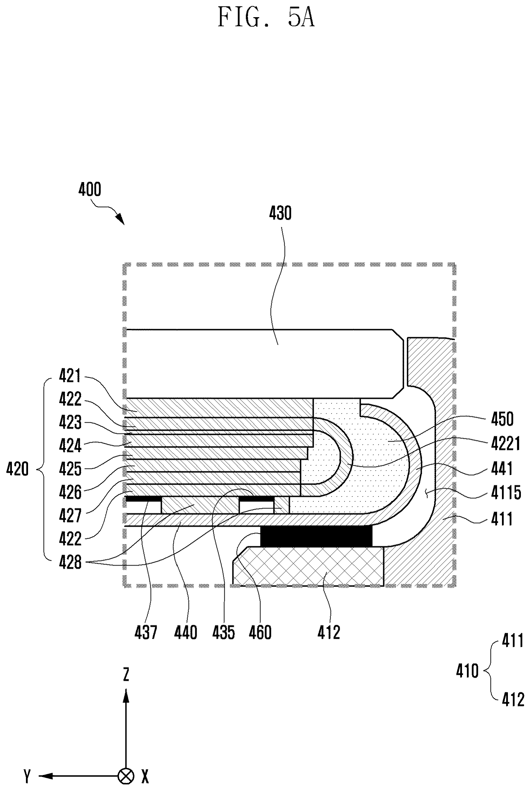

In an embodiment, the window cover 430 may be disposed on one surface of a display 420 (see FIG. 5A). The window cover 430 may be substantially identical in configuration to a front surface cover 320 in FIG. 3.

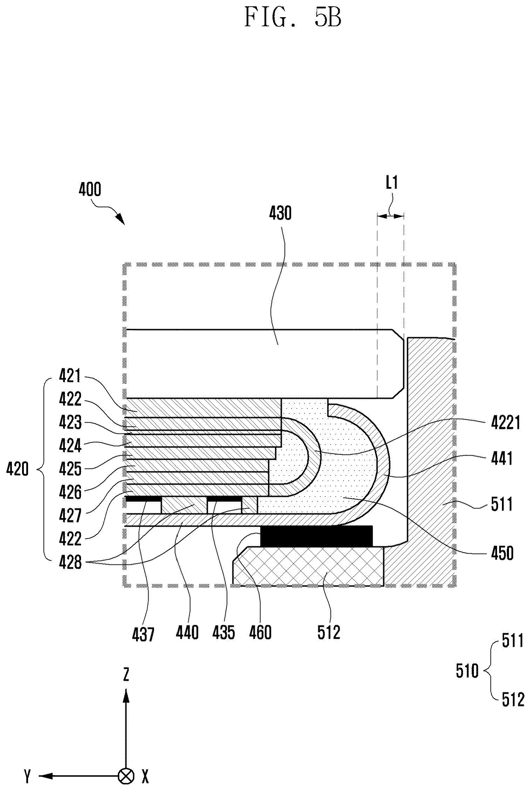

FIGS. 5A and 5B are partial cross-sectional views illustrating a plate 440 and a molded part 450 according to various embodiments.

FIGS. 5A and 5B may be cross-sectional views illustrating the electronic device 400 when viewed in a cross-section taken along line A-A' illustrated in FIG. 4. FIG. 5A may be a cross-sectional view illustrating the electronic device 400 including the housing 410 having a concave area 4115. FIG. 5B may be a cross-sectional view illustrating the electronic device 400 including a housing 510 that does not have the concave area 4115.

In an embodiment, the electronic device 400 may include the housing 410, the display 420, the window cover 430, the plate 440, the molded part 450, and/or a bonding member 460.

In an embodiment, one direction of the display 420 may refer, for example, to a positive Z-axis direction, and the other direction of the display 420 may refer, for example, to a negative Z-axis direction.

In an embodiment, the window cover 430 may be disposed in one direction (e.g., the positive Z-axis direction) of the display 420. The window cover 430 may serve to protect the display 420 from an external impact.

In an embodiment, at least a part of the plate 440 may be disposed in the other direction (e.g., the negative Z-axis direction) of the display 420.

In an embodiment, the display 420 may include at least one layer. For example, the display 420 may include joining layers 421, 423, 425, 427, and 428, a panel layer 422, a compensation layer 426, and/or a protective layer 424.

In an embodiment, the display 420 may include a first joining layer 421, a second joining layer 423, a third joining layer 425, a fourth joining layer 427, and/or a fifth joining layer 428. The first joining layer 421, the second joining layer 423, the third joining layer 425, the fourth joining layer 427, and/or the fifth joining layer 428 may serve to join layers of the display 420 or join the display 420 and other components of the electronic device 400. For example, the joining layers 421, 423, 425, 427, and 428 may each include at least one of an optical clear adhesive (OCA), a pressure sensitive adhesive (PSA), a thermally reactive bonding agent, a general bonding agent, and a double-sided tape.

In an embodiment, the compensation layer 426 may serve to allow the panel layer 422 to be bent while having a predetermined radius. The compensation layer 426 may be disposed between portions of the panel layer 422 extending while being bent. The panel layer 422 may be bent while maintaining a predetermined radius, and damage to the panel layer 422 may be prevented and/or reduced. The compensation layer 426 may include a level difference compensation tape that compensates for level differences between the layers of the display 420.

In an embodiment, the fifth joining layer 428 may be joined to the plate 440 and serve to fix the display 420 to the plate 440.

FIGS. 5A and 5B illustrate that the display 420 includes the fifth joining layer 428 joined to the plate 440. However, this configuration is provided for illustrative purposes only, and the shape of the display 420 may not be limited thereto.

In an embodiment, the display 420 may not include the fifth joining layer 428. For example, in order to define an interval for protecting the display 420, the display 420 may be positioned to be spaced apart from the plate 440 without including the fifth joining layer 428. In case that the display 420 is positioned to be spaced apart from the plate 440, the plate 440 may be fixed and attached to a part of the molded part 450.

In an embodiment, the panel layer 422 may be a layer including a display panel. For example, the display panel may include at least some of an organic light-emitting layer, a drive circuit layer, a wiring layer, which connects the drive circuit layer and a printed circuit board, a touch layer, a polarizing layer, and a filter layer. For example, the display panel may include a substrate on which the organic light-emitting layer, the drive circuit layer, the wiring layer, the touch layer, the polarizing layer, and/or the filter layer are disposed. In an embodiment, the panel layer 422 may include a bending area 4221 extending while being bent.

In an embodiment, the protective layer 424 may serve to protect the panel layer 422 from an external impact. The protective layer 424 may include a buffer material for protecting the panel layer 422. For example, the protective layer 424 may include polyimide (PI) or sponge.

In an embodiment, a control circuit 435 and a flexible printed circuit board 437 may be disposed on the panel layer 422 of the display 420. The control circuit 435 may include a display driver IC (DDI) and/or a touch display driver IC (TDDI). The flexible printed circuit board 437 may be electrically connected to the panel layer 422 and transmit a signal, which is received from the control circuit 435, to the printed circuit board in the electronic device 400.

In an embodiment, the control circuit 435 may be provided in the form of a chip-on-panel (COP) structure or a chip-on-film (COF) structure and attached to the panel layer 422. As illustrated in FIG. 5A, the chip-on-panel (COP) structure may refer, for example, to a structure in which the control circuit 435 is attached directly to the panel layer 422. The chip-on-film (COF) structure may refer, for example, to a structure in which the control circuit 435 is disposed on the flexible printed circuit board 437 without being attached directly to the panel layer 422. FIG. 5A illustrates that the control circuit 435 is disposed in the form of the chip-on-panel (COP) structure on the panel layer 422. However, this configuration is provided for illustrative purposes only. The control circuit 435 may be disposed in the form of the chip-on-film (COF) structure.

In an embodiment, the fifth joining layer 428 may be disposed at a position that does not overlap the control circuit 435 and the flexible printed circuit board 437. Because the control circuit 435 and the flexible printed circuit board 437 do not overlap the fifth joining layer 428, the control circuit 435 and the flexible printed circuit board 437 may be disposed while having a predetermined interval with the plate 440.

In an embodiment, because the control circuit 435 and the flexible printed circuit board 437 are disposed to have the predetermined interval with the plate 440, it is possible to reduce or prevent damage to the control circuit 435 and the flexible printed circuit board 437 caused by an external impact.

In an embodiment, the fifth joining layer 428 may be disposed in at least a part between the panel layer 422 and the plate 440. For example, the fifth joining layer 428 may be disposed at a position that does not overlap the control circuit 435 and the flexible printed circuit board 437 in the space between the panel layer 422 and the plate 440. The fifth joining layer 428 may allow the panel layer 422 and the plate 440 to maintain a predetermined interval.

In an embodiment, the fifth joining layer 428 may be disposed in at least a part between the panel layer 422 and the plate 440. For example, the fifth joining layer 428 may be disposed in a space between the panel layer 422 and the plate 440, e.g., a space positioned between the control circuit 435 and the molded part 450. The fifth joining layer 428, which is disposed in the space positioned between the control circuit 435 and the molded part 450, may serve to prevent the molded part 450 from moving in an inward direction (e.g., a positive Y-axis direction) of the display 420.

In an embodiment, the display 420 may include the bending area 4221. The bending area 4221 may be an area positioned at a distal end of the display 420. For example, with reference to FIGS. 5A and 5B, the bending area 4221 may be an area connected to a part of the panel layer 422 to which the control circuit 435 disposed in the form of the chip-on-panel (COP) structure is attached. The bending area 4221 may be an area in which the panel layer 422 of the display 420 extends while being bent.

In an embodiment, the housing 410 may include a first support area 411 and/or a second support area 412. The first support area 411 may extend in the height direction (e.g., the Z-axis direction) of the electronic device 400, and the second support area 412 may extend in the longitudinal direction (e.g., the Y-axis direction) of the electronic device 400. For example, the first support area 411 may include a lateral bezel structure 218. For example, the second support area 412 may include a support member 311.

In an embodiment, the bonding member 460 may be disposed between the plate 440 and the second support area 412 of the housing 410. The plate 440 and the housing 410 may be coupled by the bonding member 460.

In an embodiment, the molded part 450 may be disposed on one surface of the plate 440, and the bonding member 460 may be disposed on the other surface of the plate 440 opposite to one surface of the plate 440. For example, the bonding member 460 may be a double-sided tape or a general bonding agent including a bonding material.

In an embodiment, in the electronic device 400, the molded part 450 is not disposed on the other surface (e.g., a surface directed toward a negative Z-axis) of the plate 440, such that a thickness (e.g., a length in the Z-axis direction) of the electronic device 400 may be reduced.

In the electronic device 400 according to an embodiment, the bonding member 460 may be attached to the plate 440 without being attached to the molded part 450. Because the bonding member 460 is attached to the plate 440, it is possible to prevent or reduce damage to the molded part 450 during a process of reassembling the electronic device 400.

The housing 410 according to an embodiment may be formed in a shape at least partially recessed concavely. For example, with reference to FIG. 5A, the first support area 411 of the housing 410 may include the concave area 4115. The concave area 4115 may be an area in which a portion of the first support area 411 of the housing 410, which faces the bending area 4221 of the display 420, is formed in a shape recessed concavely.

In an embodiment, in case that the first support area 411 of the housing 410 includes the concave area 4115, it may be easy to ensure the interval between the first support area 411 and the molded part 450. The interval between the first support area 411 and the molded part 450 is ensured by the concave area 4115, which may prevent or reduce an external impact to be applied to the molded part 450.

In an embodiment, in case that the first support area 411 of the housing 410 includes the concave area 4115, the black masking (BM) area of the electronic device 400 may be reduced. With reference to FIG. 5B, in case that the housing 510 includes the concave area 4115, a part of the molded part 450 and a part of the plate 440 may be disposed in the concave area 4115, which may shorten a length of the window cover 430. For example, in the electronic device 400 in FIG. 5A, because the housing 410 includes the concave area 4115, the length of the window cover 430 may decrease by a first length L1 in comparison with the electronic device 400 in FIG. 5B in which the housing 510 does not include the concave area 4115. In the electronic device 400 according to an embodiment, the length of the window cover 430 may be shortened, which may reduce the black masking (BM) area.

The housing 510 according to an embodiment may extend in one direction without including the concave area 4115. For example, with reference to FIG. 5B, a first support area 511 of the housing 510 according to an embodiment may extend in a direction (e.g., the Z-axis direction) parallel to the height direction of the electronic device 400 without having the concave area 4115. For example, a second support area 512 may extend in a direction substantially perpendicular to the first support area 511.

In an embodiment, the plate 440 may include an extension area 441 extending and spaced apart from the bending area 4221 of the display 420. The extension area 441 according to an embodiment may extend in a shape that surrounds an outer periphery of the bending area 4221 and is spaced apart from the bending area 4221. For example, with reference to FIGS. 5A and 5B, the extension area 441 may extend while being bent in a semicircular shape from the outer periphery of the bending area 4221.

In an embodiment, the molded part 450 may be disposed between the bending area 4221 of the display 420 and the extension area 441 of the plate 440. For example, the molded part 450 may be disposed in a space defined as the bending area 4221 and the extension area 441 are spaced apart from each other.

In an embodiment, the molded part 450 may include a material having lower strength than the plate 440. For example, the molded part 450 may include silicone, epoxy, and/or polymethyl methacrylate (PMMA). For example, the plate 440 may include metal having higher strength than the molded part 450.

In an embodiment, the extension area 441 of the plate 440, which has higher strength than the molded part 450, may surround the molded part 450 and protect the molded part 450 from an external impact. Because the extension area 441 of the plate 440 absorbs an impact applied from the outside, it is possible to prevent the impact from being applied directly to the molded part 450.

In an embodiment, the inward direction of the bending area 4221 may refer, for example, to a direction directed toward the display 420 from the bending area 4221. An outward direction of the bending area 4221 may refer, for example, to a direction directed toward the plate 440 from the bending area 4221.

In an embodiment, the molded part 450 may be formed by injecting a molding material into the space defined between the display 420 and the plate 440 and curing the molding material. In an embodiment, at least a part of the molded part 450 may be disposed in the inward direction of the bending area 4221. For example, the molded part 450 may be formed by filling a space, which is positioned in the inward direction of the bending area 4221, with a molding material and then curing the molding material.

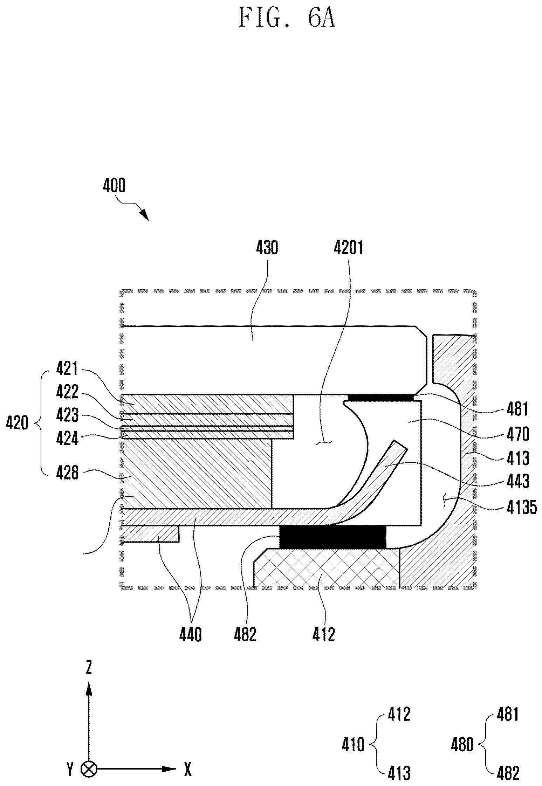

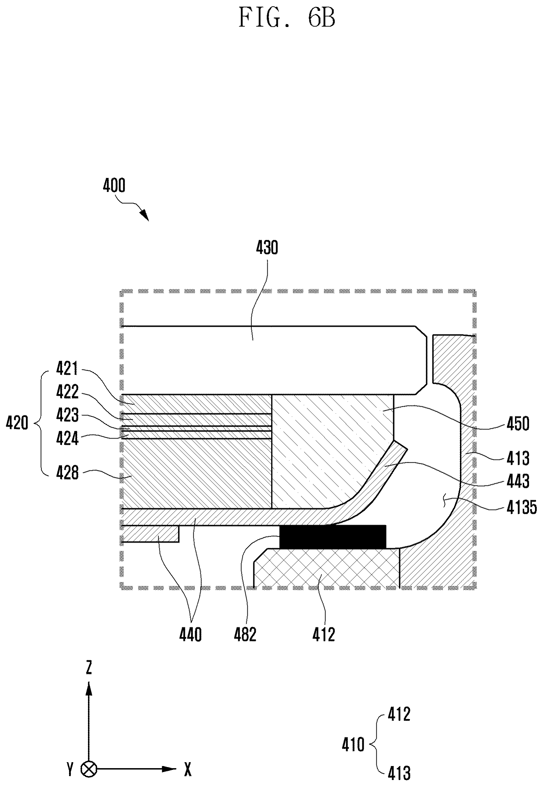

FIGS. 6A and 6B are partial cross-sectional views illustrating an injection-molded part 470 and the molded part 450 according to various embodiments.

FIGS. 6A and 6B are cross-sectional views illustrating the electronic device 400 when viewed in a cross-section taken along line B-B' illustrated in FIG. 4.

FIG. 6A is a cross-sectional view illustrating the plate 440 and the injection-molded part 470 according to various embodiments. FIG. 6B is a cross-sectional view illustrating the plate 440 and the molded part 450 according to various embodiments.

With reference to FIG. 6A, the electronic device 400 according to an embodiment may include the housing 410, the display 420, the window cover 430, the plate 440, the injection-molded part 470 and/or an injection-molded part bonding member 480.

With reference to FIG. 6A, in an embodiment, the window cover 430 may be disposed in one direction (e.g., the positive Z-axis direction) of the display 420. In an embodiment, at least a part of the plate 440 may be disposed in the other direction (e.g., the negative Z-axis direction) of the display 420.

With reference to FIG. 6A, in an embodiment, the plate 440 may include an inclined area 443. The inclined area 443 may be an area in which a part of the plate 440 extends in a direction inclined with respect to a direction in which the display 420 extends. For example, with reference to FIG. 6, the inclined area 443 may extend in a direction (e.g., one direction between the X-axis and the Y-axis) inclined with respect to a direction parallel to the X-axis direction.

With reference to FIG. 6A, in an embodiment, the injection-molded part 470 may be disposed to surround the inclined area 443 of the plate 440. For example, the injection-molded part 470 may be formed by an injection molding process to surround the inclined area 443.

With reference to FIG. 6A, in an embodiment, the manufacturing time is additionally required to cure the molded part 450 in FIGS. 5A and 5B. Therefore, the molded part 450 having shape illustrated in FIG. 5A may be formed only on a part of the distal end of the electronic device 400, and the injection-molded part 470 having a shape illustrated in FIG. 6A may be formed on the remaining part of the distal end. For example, in the electronic device 400 in FIG. 4, the molded part 450 having the shape illustrated in FIG. 5A may be formed only on the distal end directed in the negative Y-axis direction, and the injection-molded part 470 having the shape illustrated in FIG. 6A may be formed on the remaining distal end of the electronic device 400.

With reference to FIG. 6A, in an embodiment, a separation space 4201 may be defined between the display 420 and the inclined area 443 of the plate 440. The separation space 4201 may be an empty space in which the molded part 450 and the injection-molded part 470 are not disposed.

With reference to FIG. 6A, in an embodiment, the display 420 may be disposed to be spaced apart from at least a part of the plate 440. For example, the display 420 may be disposed to be spaced apart from the inclined area 443 of the plate 440.

With reference to FIG. 6A, in an embodiment, the housing 410 may include the second support area 412 and/or a third support area 413. The second support area 412 may extend in the width direction (e.g., the X-axis direction) and the longitudinal direction (e.g., the Y-axis direction) of the electronic device 400, and the third support area 413 may extend in the height direction (e.g., the Z-axis direction) and the longitudinal direction (e.g., the Y-axis direction) of the electronic device 400. For example, the third support area 413 may include the lateral bezel structure 218. For example, the second support area 412 may include the support member 311.

With reference to FIG. 6A, the housing 410 according to an embodiment may be formed in a shape at least partially recessed concavely. For example, with reference to FIG. 6A, the third support area 413 of the housing 410 may include a concave area 4135. The concave area 4135 may be an area in which a portion of the third support area 413 of the housing 410, which faces the inclined area 443 of the plate 440, is formed in a shape recessed concavely.

In an embodiment, the injection-molded part bonding member 480 may be disposed on the injection-molded part 470. For example, the injection-molded part bonding member 480 may include a first injection-molded part bonding member 481 and/or a second injection-molded part bonding member 482. The injection-molded part 470 may be attached to the window cover 430 by means of the first injection-molded part bonding member 481. The injection-molded part 470 may be attached to the housing 410 by means of the second injection-molded part bonding member 482.

With reference to FIG. 6B, the electronic device 400 according to an embodiment may include the molded part 450 on the cross-section of the electronic device 400 taken along line B-B'. For example, the electronic device 400 according to an embodiment may not only include the molded part 450 on the cross-section of the electronic device 400 taken along line A-A', but also include the molded part 450 on the cross-section taken along line B-B'. In the electronic device 400 illustrated in FIG. 6B, the molded part 450 may extend to define a closed loop along a periphery of the electronic device 400. In case that the molded part 450 extends to define a closed loop along the periphery of the electronic device 400, like the electronic device 400 illustrated in FIG. 6B, the waterproof performance and/or dustproof performance of the electronic device 400 may be improved.

With reference to FIG. 6B, in the electronic device 400 according to an embodiment, the molded part 450 is disposed in a direction directed toward the outside of the display 420 (e.g., the positive X-axis direction based on the display 420). In an embodiment, the molded part 450 may be formed between the window cover 430 and the plate 440.

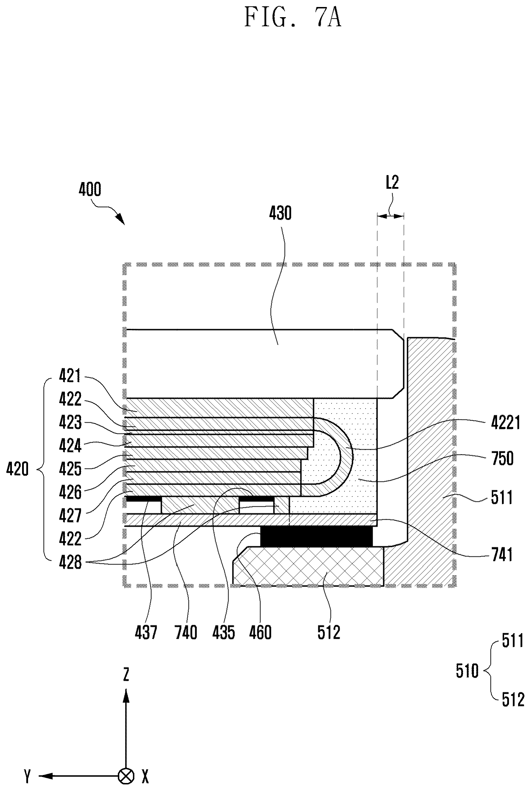

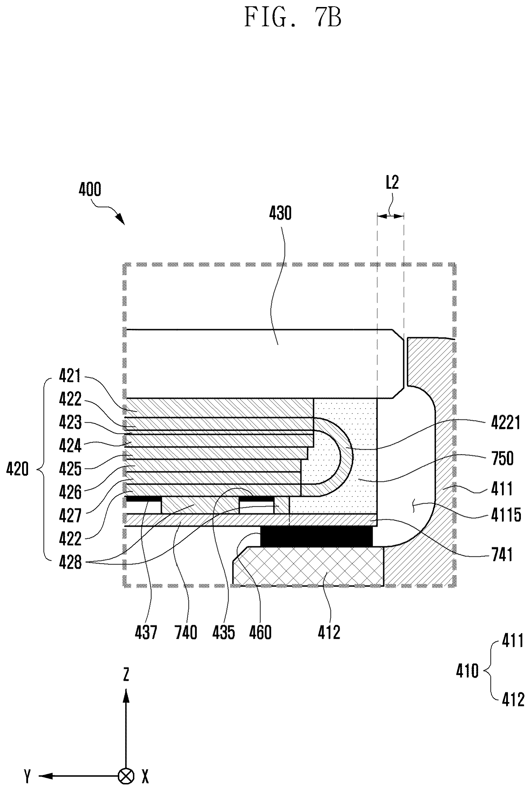

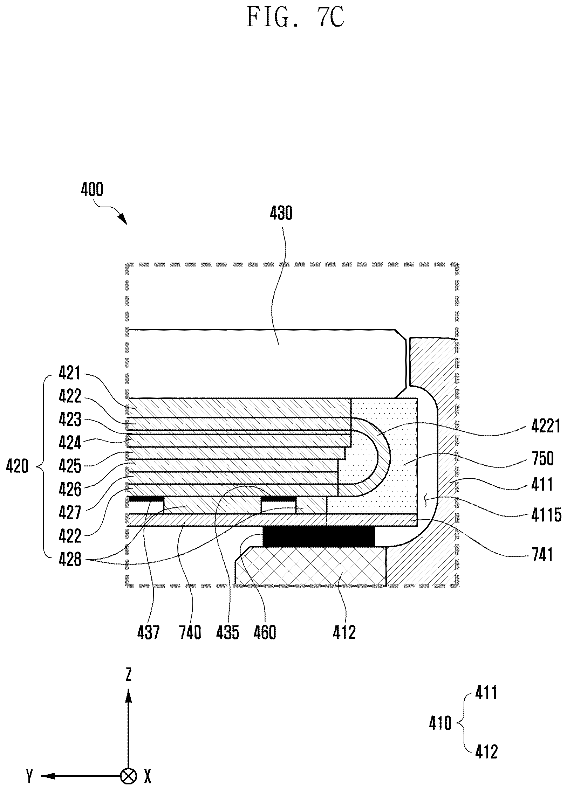

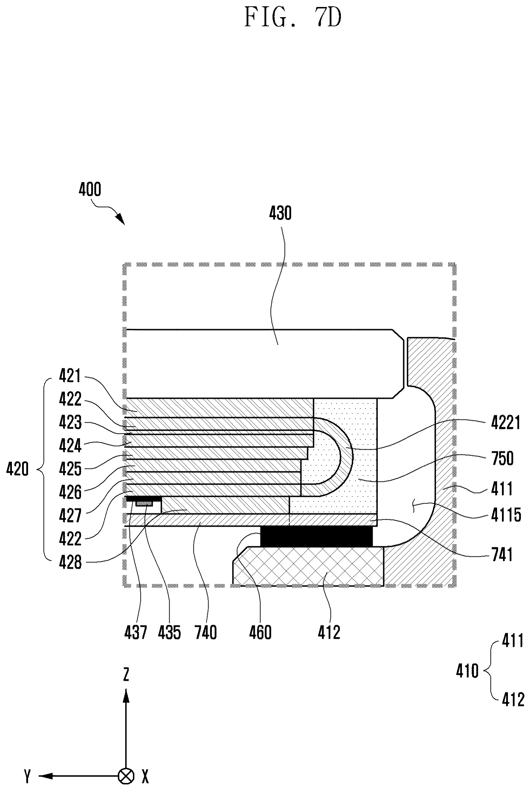

FIGS. 7A, 7B, 7C, and 7D are partial cross-sectional views illustrating a plate 740 and a molded part 750 according to various embodiments.

To describe the electronic device 400 in FIGS. 7A, 7B, 7C, and 7D, the elements, which are substantially the same as the elements of the electronic device 400 in FIG. 5A, will be designated by the same reference numerals, and a detailed description thereof may not be repeated here.

The electronic device 400 according to an embodiment may include the plate 740 disposed in the other direction (e.g., the negative Z-axis direction) that is a direction opposite to one direction (e.g., the positive Z-axis direction) of the display 420.

In an embodiment, a part of the plate 740 may be disposed to be spaced apart from the bending area 4221 of the display 420. For example, the plate 740 may include an extension area 741 disposed to be spaced apart from the bending area 4221 of the display 420 in the height direction (e.g., the Z-axis direction) of the electronic device 400.

In an embodiment, the plate 740 may extend in a direction parallel to the longitudinal direction (e.g., the Y-axis direction) of the electronic device 400. For example, both the extension area 741 of the plate 740 and the remaining area of the plate 740, which excludes the extension area 741, may extend in the direction parallel to the longitudinal direction (e.g., the Y-axis direction) of the electronic device 400.

The molded part 750 according to an embodiment may be provided at the distal end of the display 420 (e.g., the distal end of the display 420 based on the Y-axis direction) and disposed between the window cover 430 and the extension area 741.

In an embodiment, the molded part 750 may be disposed on one surface of the extension area 741 of the plate 740. For example, one surface of the extension area 741 may refer, for example, to a surface of the extension area 741 that faces the window cover 430 (e.g., a surface directed in the positive Z-axis direction).

With reference to FIG. 7A, the first support area 511 of the housing 510 according to an embodiment may extend in the direction (e.g., the Z-axis direction) parallel to the height direction of the electronic device 400 without including a concavely formed portion. For example, the second support area 512 may extend in the direction substantially perpendicular to the first support area 511. The first support area 511 may be positioned to be spaced apart from the molded part 750 in the longitudinal direction (e.g., the Y-axis direction) of the electronic device 400. The bonding member 460 may be disposed on one surface of the second support area 512. The plate 740 may be bonded to the second support area 512 by means of the bonding member 460.

In an embodiment, one side surface of the molded part 750 and one side surface of the extension area 741 may be formed at the same position based on the longitudinal direction (e.g., the Y-axis direction) of the electronic device 400. With reference to FIG. 7B, one side surface of the molded part 750 may refer, for example, to a side surface positioned in a direction (e.g., the negative Y-axis direction) in which the molded part 750 faces the first support area 411. One side surface of the extension area 741 may refer, for example, to a side surface positioned in a direction (e.g., the negative Y-axis direction) in which the extension area 741 faces the first support area 411.

The housing 410 according to an embodiment may be formed in a shape at least partially recessed concavely. For example, with reference to FIGS. 7B and 7C, the housing 410 may include the concave area 4115 to protect the molded part 750 when the first support area 411 is deformed by an impact applied from the outside. For example, the concave area 4115 may be an area in which a portion of the housing 410, which faces the bending area 4221 of the display 420, is formed in a shape recessed concavely. The concave area 4115 may be formed to face one side surface of the molded part 750 and one side surface of the extension area 741.

In an embodiment, in the electronic device 400, the length of the window cover 430 may decrease by a second length L2. For example, in the electronic device 400 in FIG. 7C, one side surface of the molded part 750 and one side surface of the extension area 741 may be formed at the same position based on the longitudinal direction of the electronic device 400, and one side surface of the molded part 750 and one side surface of the extension area 741 may be disposed in the concave area 4115, such that the length of the window cover 430 may decrease by the second length L2 in comparison with the electronic device 400 in FIGS. 7A and 7B. In the electronic device 400 according to an embodiment, the length of the window cover 430 may be shortened, which may reduce the black masking (BM) area.

FIGS. 7A, 7B, and 7C illustrate that one side surface of the molded part 750 and one side surface of the extension area 741 of the plate 740 are formed at the same position based on the longitudinal direction (e.g., the Y-axis direction) of the electronic device 400. However, this configuration is provided for illustrative purposes only. One side surface of the extension area 741 of the plate 740 may further extend than one side surface of the molded part 750. For example, a distance between the first support area 411 and the molded part 750 may be decreased by the decrease in the second length L2 in FIG. 7C, and the molded part 750 may be damaged by an external impact. In order to reduce or prevent damage to the molded part 750, one side surface of the plate 740 may further extend toward the first support area 411 than one side surface of the molded part 750. For example, because one side surface of the extension area 741 of the plate 740 further extend toward the first support area 411 than one side surface of the molded part 750, an impact may be applied to the extension area 741 first before being applied to the molded part 750. In case that one side surface of the extension area 741 further extends toward the first support area 411 than one side surface of the molded part 750, the plate 740 may absorb an impact applied from the outside, which may prevent or reduce an impact applied directly to the molded part 750.

With reference to FIGS. 7B and 7C, one side surface of the molded part 750 may be exposed to the outside of the plate 740, which may make it easy for a manufacturer to identify the amount of injection of the molding material during a process of injecting the molding material for forming the molded part 750.

In an embodiment, in the area in which the bending area 4221 of the display 420 is positioned in the electronic device 400, the plate 440 and the molded part 450 having the shapes illustrated in FIG. 5A and the plate 740 and the molded part 750 having the shapes illustrated in FIG. 7C may be alternately formed in the width direction (e.g., the X-axis direction) of the electronic device 400.

In the electronic device 400 according to an embodiment, the molded part 750 may be formed in advance of the plate 740. The plate 740 may be disposed by attaching the molded part 750 formed in advance. For example, in order to attach the molded part 750 and the plate 740, a bonding member may be additionally disposed between at least a part of the molded part 750 and the plate 740.

FIGS. 7A, 7B, and 7C illustrate that the control circuit 435 is attached in the form of the chip-on-panel (COP) structure to the panel layer 422. However, this configuration is provided for illustrative purposes only, and the attachment shape of the control circuit 435 is not limited thereto. For example, the control circuit 435 may be disposed in the form of the chip-on-film (COF) structure. With reference to FIG. 7D, the control circuit 435 may be disposed on the flexible printed circuit board 437 without being attached directly to the panel layer 422.

With reference to FIG. 7D, in case that the control circuit 435 according to an embodiment is attached in the form of the COF structure to the panel layer 422, the fifth joining layer 428 may be disposed at a position that does not overlap the flexible printed circuit board 437 and the control circuit 435. For example, the fifth joining layer 428 may be disposed in a space between the panel layer 422 and the plate 740, e.g., a space between the flexible printed circuit board 437 and the molded part 750. The fifth joining layer 428 may serve to attach the plate 740 to the panel layer 422. The fifth joining layer 428 may serve to prevent the molded part 750 from moving in the inward direction (e.g., the positive Y-axis direction) of the display 420.

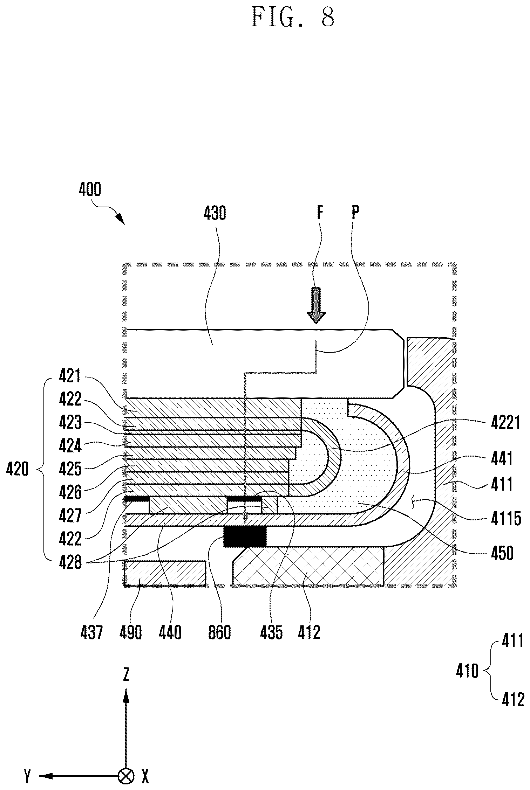

FIG. 8 is a partial cross-sectional view illustrating a bonding member 860 according to various embodiments.

To describe the electronic device 400 in FIG. 8, the elements, which are substantially the same as the elements of the electronic device 400 in FIG. 5A, will be designated by the same reference numerals, and a detailed description thereof may not be repeated here.

In an embodiment, the electronic device 400 may include the bonding member 860 that serves to attach the plate 440 to the housing 410. The bonding member 860 may be disposed between the plate 440 and the second support area 412 of the housing 410 and attach the plate 440 to the second support area 412 of the housing 410.

In an embodiment, the bonding member 860 may be disposed to be spaced apart from the position, at which the molded part 450 is formed, in the longitudinal direction of the electronic device 400. For example, with reference to FIG. 8, because the bonding member 860 is disposed to be spaced apart from the molded part 450 in the Y-axis direction, the bonding member 860 and the molded part 450 may not overlap each other in the Z-axis direction.

In case that an external force F is applied to the electronic device 400 according to an embodiment in the height direction (e.g., the Z-axis direction) of the electronic device 400, the external force F may be transmitted into the electronic device 400 along a transmission path P illustrated in FIG. 8. In case that the external force F is transmitted along the transmission path P, the external force F is transmitted while avoiding the molded part 450 having relatively low strength, which makes it more advantageous for the electronic device 400 to withstand the external force F applied in the height direction (e.g., the Z-axis direction).

In an embodiment, the electronic device 400 may include a printed circuit board 490. The printed circuit board 490 may be disposed to be spaced apart from the second support area 412 of the housing 410 in the longitudinal direction (e.g., the Y-axis direction) of the electronic device 400.

In an electronic device 400 having the shape illustrated in FIG. 8, because the bonding member 860 is disposed at the position that does not overlap the molded part 450, the bonding member 860 is formed at a position moved toward the printed circuit board 490, such that a space in which the printed circuit board 490 may be disposed may be relatively reduced. In the electronic device 400 having the shape illustrated in FIG. 5A, the bonding member 460 is disposed at the position that overlaps the molded part 450, such that the space in which the printed circuit board 490 may be disposed may be relatively increased.

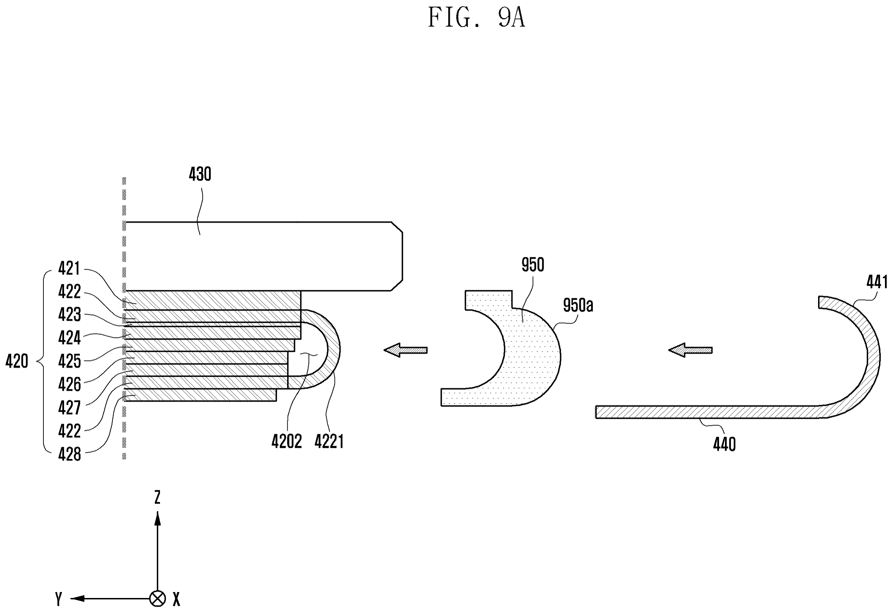

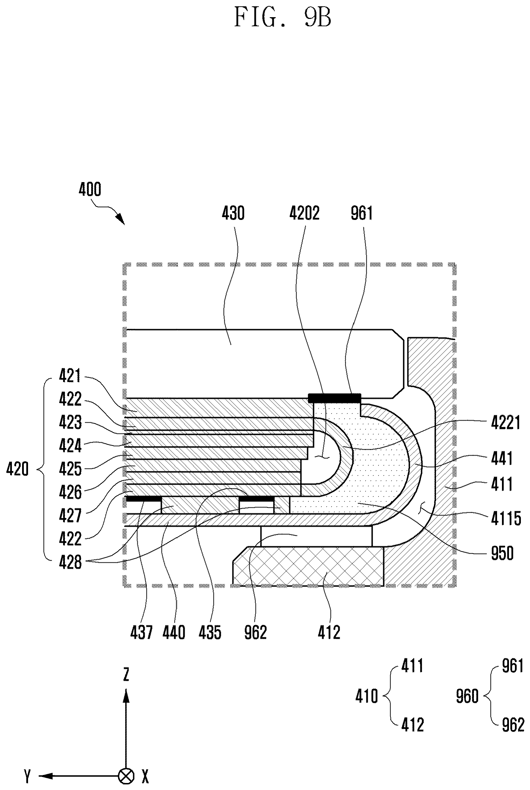

FIGS. 9A and 9B are partial cross-sectional views illustrating a state in which a molded part 950, the display 420, and the plate 440 are coupled according to various embodiments.

To describe the electronic device 400 in FIGS. 9A and 9B, the elements, which are substantially the same as the elements of the electronic device 400 in FIG. 5A, will be designated by the same reference numerals, and a detailed description thereof may not be repeated here.

In an embodiment, the molded part 950 may be disposed on the display 420 and the plate 440 after being cured. For example, with reference to FIG. 9A, the molded part 950 may be attached to the display 420 and the plate 440 in a state in which a molding material is cured and hardened.

In case that the cured molded part 950 is disposed on the display 420 and the plate 440, it is possible to reduce the time required to cure the molded part 950 and reduce the inflow of outside foreign substances into the molding material during the process of forming the molded part 950 in comparison with the case in which the molded part 450 is formed by injecting the molding material between the display 420 and the plate 440 and then curing the molding material.

In an embodiment, the molded part 950 may be formed by being cured so that at least a part of the molded part 950 includes a bent shape. For example, the molded part 950 may be formed by being cured in a state in which one surface 950a of the molded part 950 is bent.

In an embodiment, a bonding agent (not illustrated) may be disposed on one surface 950a of the molded part 950. The molded part 950 may be attached to the plate 440 by means of the bonding agent (not illustrated) disposed on one surface 950a.

With reference to FIG. 9A, the cured molded part 950 may be disposed to surround the bending area 4221 of the display 420, and the extension area 441 of the plate 440 may be attached to one surface 950a of the molded part 950.

With reference to FIG. 9B, the electronic device 400 may include bonding members 960. For example, the bonding members 960 may include a first bonding member 961 and/or a second bonding member 962.

In an embodiment, the first bonding member 961 may be disposed between the window cover 430 and the molded part 950. The molded part 950 may be attached to the window cover 430 using the first bonding member 961.

In an embodiment, the second bonding member 962 may be disposed between the plate 440 and the second support area 412 of the housing 410. A part of the plate 440 may be attached to the second support area 412 of the housing 410 using the second bonding member 962.

In an embodiment, the bonding members 960 may further include a bonding member in addition to the first bonding member 961 and/or the second bonding member 962. For example, the bonding members 960 may further include a bonding member positioned between at least a part of the molded part 950 and the plate 440 to attach the molded part 950 and the plate 440.

In an embodiment, a bending space 4202 may be formed in an inward direction of the bending area 4221 of the display 420. The bending space 4202 may be a space formed in the inward direction of the bending area 4221, and the molded part 950 is not disposed in the bending space 4202. In case that the bending space 4202 is formed in the display 420, the display 420 may more advantageously withstand an external impact.

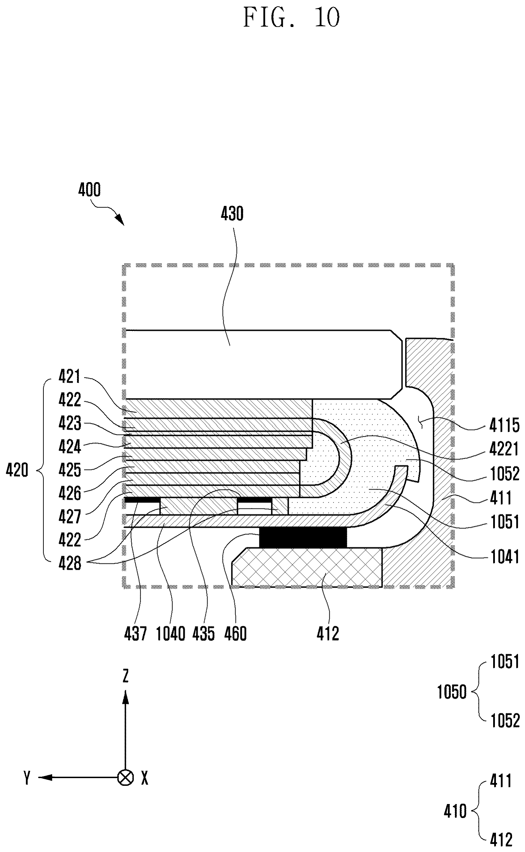

FIG. 10 is a partial cross-sectional view illustrating a molded part 1050 according to various embodiments.

To describe the electronic device 400 in FIG. 10, the elements, which are substantially the same as the elements of the electronic device 400 in FIG. 5A, will be designated by the same reference numerals, and a detailed description thereof may not be repeated here.

In an embodiment, a plate 1040 may extend to expose at least a part of one side surface of the molded part 1050 to the outside of the plate 1040. One side surface of the molded part 1050 may refer, for example, to a side surface positioned in the direction (e.g., the negative Y-axis direction) in which the extension area 1050 faces the first support area 411. For example, an extension area 1041 of the plate 1040 may extend while being bent in a shape that exposes at least a part of one side surface of the molded part 1050 to the outside of the plate 1040. The plate 1040 illustrated in FIG. 10 may extend to a smaller degree than the plate 1040 in FIG. 9B. For example, a length of the extension area 1041 in FIG. 10 may be shorter than a length of the extension area 441 in FIG. 9B, such that at least a part of one side surface of the molded part 1050 may be exposed to the outside of the plate 1040.

In an embodiment, at least a part of the molded part 1050 may be disposed between the bending area 4221 of the display 420 and the extension area 1041 of the plate 1040.

In an embodiment, the molded part 1050 may include a first molded area 1051 and/or a second molded area 1052. The first molded area 1051 may be an area disposed between the bending area 4221 of the display 420 and the extension area 1041 of the plate 1040. The second molded area 1052 may be an area connected to the first molded area 1051 and configured to surround a distal end of the extension area 1041 of the plate 1040.

In an embodiment, at least a part of the second molded area 1052 of the molded part 1050 may further protrude toward the first support area 411 of the housing 410 than the extension area 1041 of the plate 1040.

In an embodiment, the second molded area 1052 may be disposed to surround three sides of the extension area 1041. For example, the second molded area 1052 may be disposed to surround a side of the extension area 1041 facing the display 420, a side of the extension area 1041 facing the window cover 430, and a side of the extension area 1041 facing the first support area 411 of the housing 410. In an embodiment, because the second molded area 1052 is disposed to surround the three sides of the extension area 1041, the molded part 1050 and the plate 1040 may be more strongly joined, which may make it easier to maintain a predetermined position of the molded part 1050 on the plate 1040.

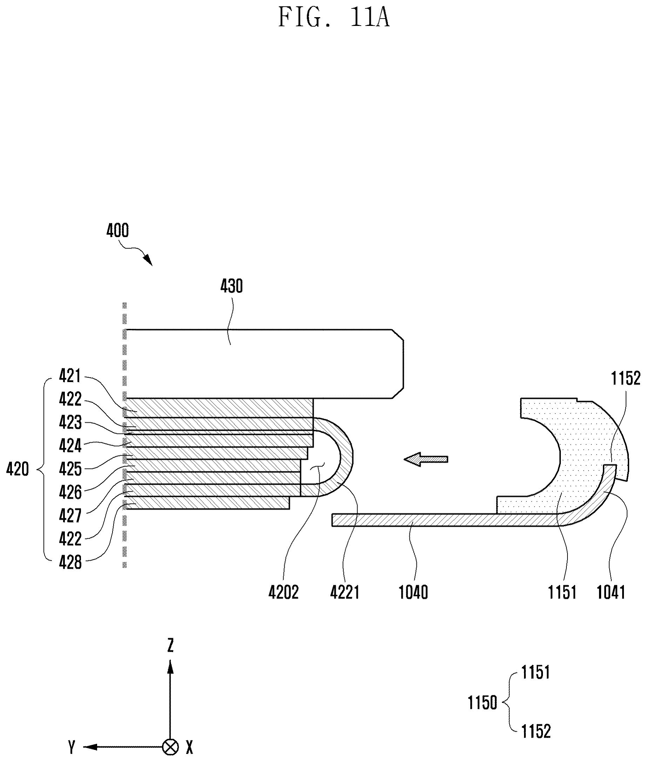

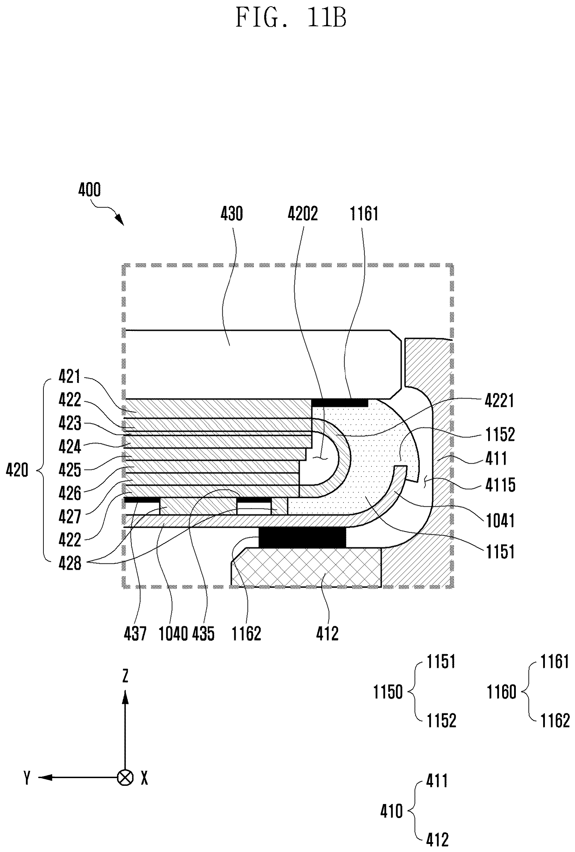

FIGS. 11A and 11B are partial cross-sectional views illustrating a state in which a molded part 1150 and the display 420 are coupled according to various embodiments.

To describe the electronic device 400 in FIGS. 11A and 11B, the elements, which are substantially the same as the elements of the electronic device 400 in FIG. 5A or 10, will be designated by the same reference numerals, and a detailed description thereof may not be repeated here.

In an embodiment, the molded part 1150 may be disposed on the display 420 and the plate 440 after being cured. For example, with reference to FIG. 11A, the molded part 1150 may be attached to the display 420 and the plate 1040 in a state in which a molding material is cured and hardened.

In an embodiment, the molded part 1150 and the plate 1040 may be formed using a dual injection molding process. For example, the molded part 1150, which surrounds a part of the plate 1040, may be formed in a cured state by the dual injection molding process. With reference to FIG. 11A, the molded part 1150 and the plate 1040, which are formed by the dual injection molding process, may be attached to the display 420.

In an embodiment, the molded part 1150, which is disposed in the cured state, may include a first molded area 1151 and/or a second molded area 1152. The first molded area 1151 may be an area disposed between the bending area 4221 of the display 420 and the extension area 1041 of the plate 1040. The second molded area 1152 may be an area connected to the first molded area 1151 and configured to surround a distal end of the extension area 1041 of the plate 1040.

With reference to FIG. 11B, the electronic device 400 may include bonding members 1160. The bonding members 1160 may include a first bonding member 1161 and/or a second bonding member 1162.

In an embodiment, the first bonding member 1161 may be disposed between the window cover 430 and the molded part 1050. For example, the molded part 1050 may be attached to the window cover 430 using the first bonding member 1161.

In an embodiment, the second bonding member 1162 may be disposed between the plate 1040 and the housing 410. For example, a part of the plate 1040 may be attached to the second support area 412 of the housing 410 using the second bonding member 1162.

In an embodiment, the bending space 4202 may be formed in the inward direction of the bending area 4221 of the display 420. The bending space 4202 may be a space formed in the inward direction of the bending area 4221, and the molded part 1150 is not disposed in the bending space 4202. In case that the bending space 4202 is formed in the display 420, the display 420 may more advantageously withstand an external impact.

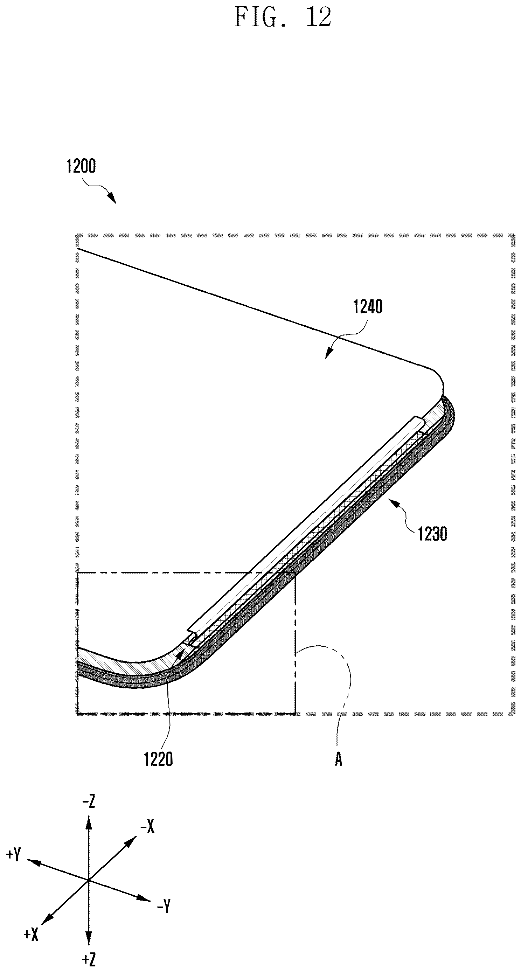

FIG. 12 is a partial exploded perspective view illustrating an electronic device 1200 according to various embodiments.

FIG. 12 may be an exploded perspective view illustrating some components of the electronic device 1200 according to various embodiments.

In the description of the electronic device 1200 according to an embodiment of the present disclosure, a width direction of the electronic device 1200 may refer, for example, to an X-axis direction, and a longitudinal direction of the electronic device 1200 may refer, for example, to a Y-axis direction. A height direction of the electronic device 1200 may refer, for example, to a Z-axis direction.

The electronic device 1200 illustrated in FIG. 12 may refer, for example, to the electronic devices 101, 200, 300, and 400 in FIGS. 1, 2, 3, and 5A or include at least a part of each of the electronic devices 101, 200, 300, and 400 in FIGS. 1, 2, 3, and 5A.

In an embodiment, the electronic device 1200 may include a display 1220, a window cover 1230, and/or a plate 1240. The display 1220, the window cover 1230, and the plate 1240 may be respectively configured to be substantially identical in shapes and functions to the display 420, the window cover 430, and the plate 440 in FIG. 5A.

Area A illustrated in FIG. 12 may be an area indicating a distal end of the plate 1240 (e.g., a distal end of the plate 1240 positioned in the negative Y-axis direction) and a distal end of the display 1220 (e.g., a distal end of the display 1220 positioned in the negative Y-axis direction).

With reference to FIG. 12, the display 1220 may be disposed in one direction (e.g., the positive Z-axis direction) of the plate 1240. The window cover 1230 may be disposed in one direction (e.g., the positive Z-axis direction) of the display 1220.

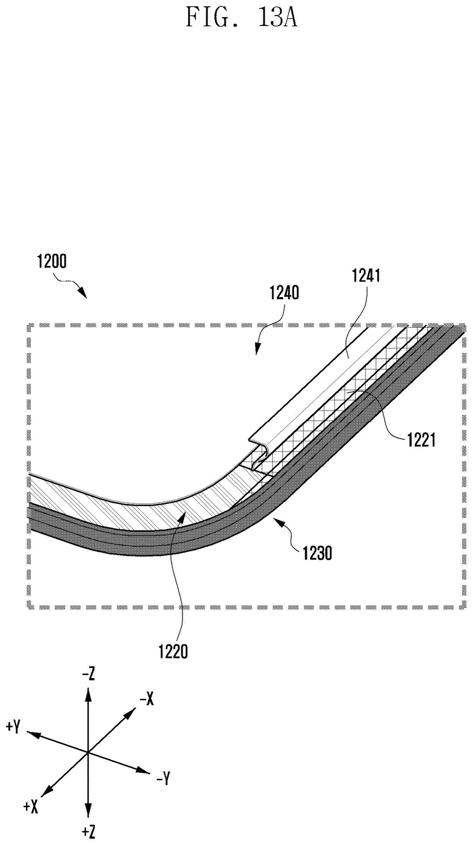

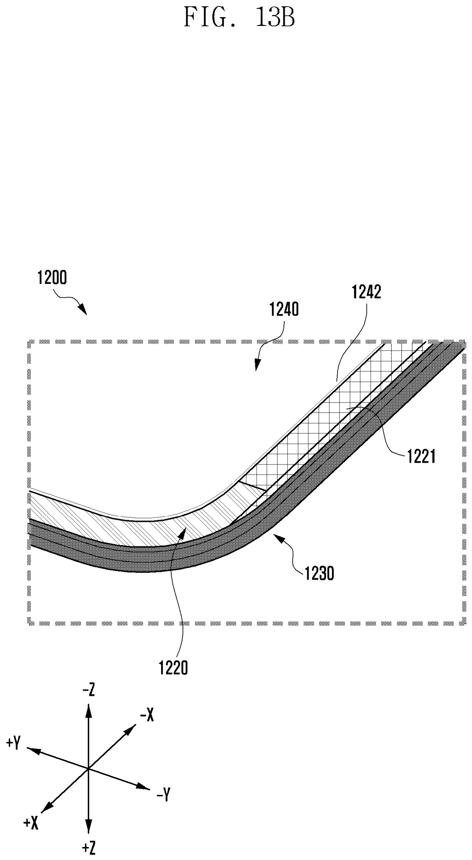

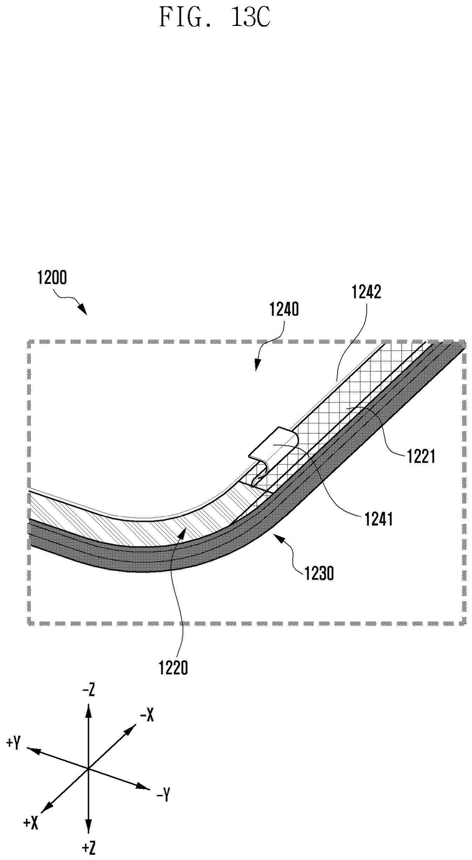

FIGS. 13A, 13B, and 13C are partial perspective views illustrating the plate 1240, the display 1220, and the window cover 1230 according to various embodiments.

FIGS. 13A, 13B, and 13C may be enlarged perspective views of area A illustrated in FIG. 12.

In an embodiment, the plate 1240 may include a first distal end area 1241 and/or a second distal end area 1242. In an embodiment, the first distal end area 1241 and the second distal end area 1242 may be formed at the distal end of the plate 1240 (e.g., the distal end of the plate 1240 positioned in the negative Y-axis direction). The first distal end area 1241 and the second distal end area 1242 may refer, for example, to areas included in the extension areas 441 and 741 of the plates 440 and 740 illustrated in FIGS. 5A and 7A.

FIG. 13A may be a partial perspective view illustrating the electronic device 1200 including the first distal end area 1241. FIG. 13B may be a partial perspective view illustrating the electronic device 1200 including the second distal end area 1242. FIG. 13C may be a partial perspective view illustrating the electronic device 1200 including the first distal end area 1241 and the second distal end area 1242.

In an embodiment, the display 1220 may include a bending area 1221. The bending area 1221 may be an area formed at the distal end of the display 1220, and a part of the display 1220 may extend while being bent in the bending area 1221.

In an embodiment, the first distal end area 1241 and the second distal end area 1242 may be formed at positions corresponding to the bending area 1221 of the display 1220. For example, the bending area 1221 of the display 1220 may be disposed in the first distal end area 1241 and the second distal end area 1242.

In an embodiment, the molded part 450 illustrated in FIG. 5A may be disposed in a space surrounded by the first distal end area 1241 of the plate 1240, the bending area 1221 of the display 1220, and the window cover 1230.

In an embodiment, the molded part 750 illustrated in FIG. 7B may be disposed in a space surrounded by the second distal end area 1242 of the plate 1240, the bending area 1221 of the display 1220, and the window cover 1230.

In an embodiment, the first distal end area 1241 may be an area identical in shape to the extension area 441 of the plate 440 in FIG. 5A. For example, with reference to FIG. 13A, the first distal end area 1241 may be an area extending while being bent. In an embodiment, the first distal end area 1241 of the plate 1240 may extend while being bent and disposed to surround an outer periphery of the bending area 1221 of the display 1220. The molded part 450 (see FIG. 5A) disposed in the first distal end area 1241 may not be exposed to the outside of the plate 1240.

In an embodiment, the second distal end area 1242 may be an area identical in shape to the extension area 741 of the plate 740 in FIG. 7A. For example, with reference to FIG. 13B, the second distal end area 1242 may be an area extending substantially in parallel with the remaining area of the plate 1240. With reference to FIG. 13B, the second distal end area 1242 may extend in a direction substantially parallel to the longitudinal direction (e.g., the Y-axis direction) of the electronic device 1200. In an embodiment, the bending area 1221 of the display 1220 may be disposed on one surface of the second distal end area 1242 of the plate 1240 (e.g., the surface directed in the positive Z-axis direction). At least a part of the molded part 750 (see FIG. 7B) disposed in the second distal end area 1242 may be exposed to the outside of the plate 1240.

With reference to FIG. 13C, the plate 1240 according to an embodiment may include the first distal end area 1241 and the second distal end area 1242. The first distal end area 1241 and the second distal end area 1242 may be alternately formed at the distal end of the plate 1240 according to an embodiment in the width direction (e.g., the X-axis direction) of the electronic device 1200. For example, a first distal end area 1242 may be formed in a partial area of the distal end of the plate 1240 and surround the outer periphery of the molded part 450 (see FIG. 5A). The second distal end area 1242 may be formed in the remaining partial area of the distal end of the plate 1240, and the molded part 750 (see FIG. 7B) may be disposed on one surface of the second distal end area 1242.

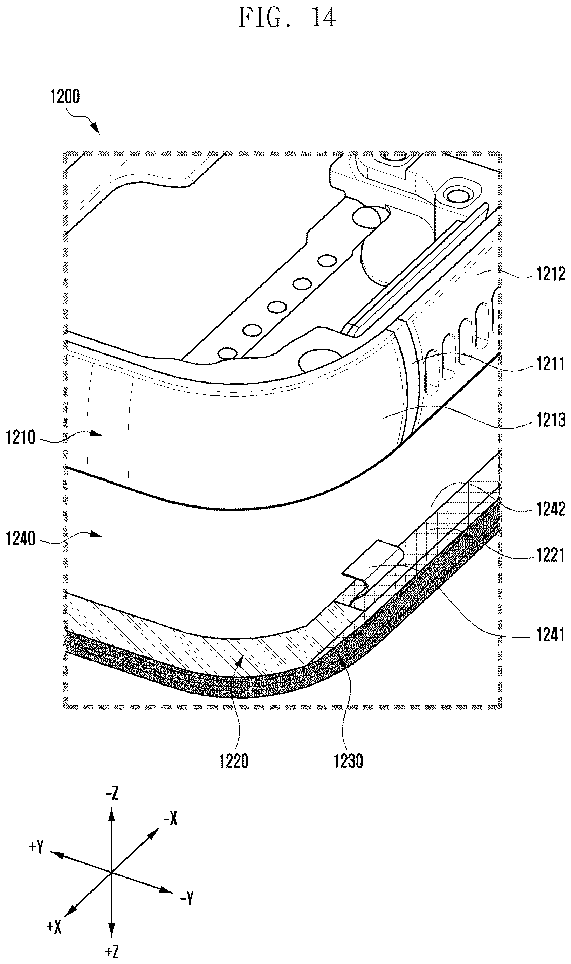

FIG. 14 is a partial exploded perspective view illustrating the electronic device 1200 including a housing 1210 according to various embodiments.

FIG. 14 may be an exploded perspective view illustrating some components of the electronic device 1200 according to various embodiments.

In an embodiment, the housing 1210 may include a segment area 1211, an antenna area 1212, and/or a non-antenna area 1213.

In an embodiment, a part of the housing 1210 may operate as a radiator of the antenna (e.g., the antenna module 197 (see FIG. 1)) of the electronic device 1200. The antenna area 1212 may be an area used as the radiator of the antenna in the area of the housing 1210. The non-antenna area 1213 may be an area that is not used as the radiator of the antenna in the area of the housing 1210. For example, the segment area 1211 may be an area that serves to adjust a length of the antenna or radiate signals.

In an embodiment, based on the segment area 1211, the antenna area 1212 may be positioned in one direction (e.g., the negative X-axis direction), and the non-antenna area 1213 may be positioned in the other direction (e.g., the positive X-axis direction).

Because the performance of the antenna may be affected by surrounding components (e.g., metal), the antenna may require the arrangement structure that may not be affected by the surrounding components. In the electronic device 1200 according to an embodiment, the components, which less affect the antenna, may be disposed at the position corresponding to the antenna area 1212 of the housing 1210, which may prevent and/or reduce the antenna from being affected by the surrounding components or reduce a degree to which the antenna is affected by the surrounding components.

In an embodiment, the first distal end area 1241, in which the plate 1240 extends while being bent, may be an area in which the metal, which affects the performance of the antenna, is relatively adjacent to the antenna area 1212. The second distal end area 1242, which extends in parallel with the remaining area of the plate 1240, may be an area in which the metal, which affects the performance of the antenna, is relatively spaced apart from the antenna area 1212. In the electronic device 1200 according to an embodiment, the first distal end area 1241 is disposed at the position corresponding to the non-antenna area 1213 in which the antenna is not formed, and the second distal end area 1242 is disposed at the position corresponding to the antenna area 1212 in which the antenna is formed, which may prevent and/or reduce the antenna from being affected by the metal or reduce a degree to which the antenna is affected by the metal.

The electronic device 400 according to an example embodiment of the present disclosure may include: a housing 410, a display 420 including a bending area 4221 disposed at a distal end of the display 420 and extending and being bent, the display 420 having at least a part surrounded by the housing 410, a window cover 430 disposed in one direction of the display 420, a plate 440 or 740 including an extension area 441 or 741 extending and spaced apart from the bending area 421 of the display 420, a plate 440 or 740 having at least a part disposed in another direction opposite to one direction of the display 420, and a molded part 450 or 750 comprising a moldable material disposed in the space surrounded by the bending area 4221 of the display 420, the window cover 430, and the extension area 441 of the plate 440.

In an example embodiment, the extension area 441 of the plate 440 may extend and be bent to surround the outer periphery of the bending area 4221 of the display 420, and the molded part 450 may be disposed between the extension area 441 and the bending area 4221 of the display 420.

In an example embodiment, the extension area 741 of the plate 740 may extend in a direction parallel to the longitudinal direction of the electronic device 400, the molded part 750 may be provided at the distal end of the display and disposed between the window cover 430 and the extension area 741, and one side surface of the molded part 750 and one side surface of the extension area 741 may be formed at a same position based on the longitudinal direction of the electronic device 400.

In an example embodiment, the electronic device 400 may further include a bonding member 460 comprising a bonding material disposed between the plate 440 and the housing 410 and configured to bond the plate 440 to the housing 410, wherein the bonding member 460 may be positioned in the direction opposite to the direction in which the molded part 450 is positioned based on the plate 440.

In an example embodiment, the electronic device 400 may further include a bonding member 860 comprising a bonding material disposed between the plate 440 and the housing 410 and configured to bond the plate 440 to the housing 410, wherein the bonding member 860 may be disposed to be spaced apart from the position at which the molded part 450 is formed based on the longitudinal direction of the electronic device 400.

In an example embodiment, the housing 410 may include a first support area 411 extending in the height direction of the electronic device 400, and a second support area 412 extending in the longitudinal direction of the electronic device 400.

In an example embodiment, the first support area 411 may include a concave area 4115 in which a portion of the display 420, facing the bending area 4221, is formed in a shape recessed concavely.

In an example embodiment, the extension area 441 may extend and be bent to surround the outer periphery of the bending area 4221 of the display 420, and at least a part of the extension area 441 may be disposed in the concave area 4115.

In an example embodiment, the extension area 741 may extend in the direction parallel to the longitudinal direction of the electronic device 400, and at least a part of the extension area 741 may be disposed in the concave area 4115.

In an example embodiment, the molded part 450 may be formed by injecting the molding material into the space surrounded by the bending area 4221 of the display 420, the window cover 430, and the extension area 441 of the plate 440 and curing the molding material.

In an example embodiment, the molded part 950 is formed in the cured state before being disposed on the display 420 and the plate 440, and the molded part 950 in the cured state may be attached to the display 420 and the plate 440.

In an example embodiment, the bending space 4202, including a space in which the molded part 950 is not disposed, may be formed in the inward direction of the bending area 4221.

In an example embodiment, the extension area 1041 of the plate 1040 may be formed to extend to expose at least a part of one side surface of the molded part 1050. The molded part 1050 may include the first molded area 1051 positioned between the extension area 1041 of the plate 1040 and the bending area 4221 of the display 420, and the second molded area 1052 connected to the first molded area 1051 and configured to surround the distal end of the extension area 1041 of the plate 1040. At least a part of the second molded area 1052 may be formed to further protrude toward the housing 410 than the extension area 1041 of the plate 1040.

In an example embodiment, the second molded area 1052 may be disposed to surround the side of the extension area 1041 facing the display 420, the side of the extension area 420 facing the window cover 430, and the side of extension area 420 facing the housing 410.

In an example embodiment, the display 420 may include a panel layer 422 including the display panel, a protective layer 424 configured to protect the display panel, and one or more joining layers 421, 423, 425, 427, and 428 configured to join the panel layer 422 and the protective layer 424. The bending area 4221 may be formed as a part of the panel layer 422 extended and being bent.

The electronic device 1200 according to an example embodiment of the present disclosure may include: a housing 410, a display 1220 including a bending area 1221 disposed at the distal end of the display 1220 and extending and being bent, the display 1220 having at least a part surrounded by the housing 410, a window cover disposed in one direction of the display 1220, a plate 1240 including an extension area 441 or 741 extending and spaced apart from the bending area 1221 of the display 1220, the plate 1240 having at least a part disposed in another direction opposite to one direction of the display 1220, and a molded part 450 or 750comprising a moldable material disposed in the space surrounded by the bending area 1221 of the display 1220, the window cover 1230, and the extension area 441 or 741 of the plate. The extension area 441 or 741 may include a first distal end area 1241 having at least a part extending and being bent to surround the outer periphery of the bending area of the display 1220, and a second distal end area 1242 extending in a direction parallel to the longitudinal direction of the electronic device 1200. The first distal end area 1241 and the second distal end area 1242 may be formed alternately in the width direction of the electronic device 1200.

In an example embodiment, one side surface of the molded part 750 disposed in the second distal end area 1242 and one side surface of the second distal end area 1242 may be formed at the same position based on the longitudinal direction of the electronic device 1200.

In an example embodiment, at least a part of the molded part 750 disposed in the second distal end area 1242 may be exposed to the outside of the plate.

In an example embodiment, the housing 1210 may include s first support area 411 extending in the height direction of the electronic device 1200, and a second support area 412 extending in the longitudinal direction of the electronic device 1200, wherein the first support area 411 may include a concave area 4115 in which a portion of the display 1220, facing the bending area 1221, is formed in a shape recessed concavely.

In an example embodiment, the housing 1210 may include an antenna area 1212 in which an antenna is formed, and the second distal end area 1242 may be disposed at the position corresponding to the antenna area 1212.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, a home appliance, or the like. The electronic devices according to embodiments of the disclosure are not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), the element may be coupled with the other element directly (e.g., wiredly), wirelessly, or via a third element.

As used in connection with an embodiment of the disclosure, the term "module" may include a unit implemented in hardware, software, or firmware, or any combination thereof, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

According to an embodiment, each component (e.g., module or program) of the above-described components may include a singular or a plurality of entities, and some of the plurality of entities may be separately disposed in any other component. According to an embodiment, one or more components or operations among the above-described components may be omitted, or one or more other components or operations may be added. Alternatively or additionally, a plurality of components (e.g., module or program) may be integrated into one component. In this case, the integrated component may perform one or more functions of each component of the plurality of components identically or similarly to those performed by the corresponding component among the plurality of components prior to the integration.

According to an embodiment, operations performed by a module, program, or other component may be executed sequentially, in parallel, repeatedly, or heuristically, or one or more of the operations may be executed in a different order or omitted, or one or more other operations may be added.

## Claims

1. An electronic device comprising:
a housing;
a display including a bending area disposed at a distal end of the display and extending and being bent, the display having at least a part surrounded by the housing;
a window cover disposed in one direction of the display;
a plate including an extension area extending and spaced apart from the bending area of the display, the plate having at least a part disposed in an other direction opposite to one direction of the display; and
a molded part comprising a moldable material disposed in a space surrounded by the bending area of the display, the window cover, and the extension area of the plate.

2. The electronic device of claim 1, wherein the extension area of the plate extends and is bent to surround an outer periphery of the bending area of the display, and the molded part disposed between the extension area and the bending area of the display.

3. The electronic device of claim 1, wherein the extension area of the plate extends in a direction parallel to a longitudinal direction of the electronic device, the molded part is provided at a distal end of the display and disposed between the window cover and the extension area, and one side surface of the molded part and one side surface of the extension area are formed at a same position based on the longitudinal direction of the electronic device.

4. The electronic device of claim 1, further comprising:
a bonding member (460)comprising a bonding material disposed between the plate and the housing and configured to bond the plate to the housing,
wherein the bonding member is positioned in a direction opposite to a direction in which the molded part is positioned with respect to the plate.

5. The electronic device of claim 1, further comprising:
a bonding member (860) comprising a bonding material disposed between the plate and the housing and configured to bond the plate to the housing,
wherein the bonding member is disposed to be spaced apart from a position at which the molded part is formed based on a longitudinal direction of the electronic device.

6. The electronic device of claim 1, wherein the housing comprises:
a first support area (411) extending in a height direction of the electronic device; and
a second support area (412) extending in a longitudinal direction of the electronic device.

7. The electronic device of claim 6, wherein the first support area comprises a concave area (4115) in which a portion of the display, facing the bending area, is formed in a shape recessed concavely.

8. The electronic device of claim 7, wherein the extension area extends and is bent to surround an outer periphery of the bending area of the display, and at least a part of the extension area is disposed in the concave area.

9. The electronic device of claim 7, wherein the extension area extends in a direction parallel to the longitudinal direction of the electronic device, and at least a part of the extension area is disposed in the concave area.

10. The electronic device of claim 1, wherein the molding material of the molded part is injection molded into a space surrounded by the bending area of the display, the window cover, and the extension area of the plate and cured.

11. The electronic device of claim 1, wherein the molded part is cured before being disposed on the display and the plate, and the cured molded part is attached to the display and the plate.

12. The electronic device of claim 11, wherein a bending space (4202), in which the molded part is not disposed, is formed in an inward direction of the bending area.

13. The electronic device of claim 1, wherein the extension area of the plate extends to expose at least a part of one side surface of the molded part,
wherein the molded part comprises:
a first molded area (1051) positioned between the extension area of the plate and the bending area of the display; and
a second molded area (1052) connected to the first molded area and configured to surround a distal end of the extension area of the plate, and
wherein at least a part of the second molded area protrudes toward the housing further than the extension area of the plate.

14. The electronic device of claim 13, wherein the second molded area is disposed to surround a side of the extension area facing the display, a side of the extension area facing the window cover, and a side of the extension area facing the housing.

15. The electronic device of claim 1, wherein the display comprises:
a panel layer (422) comprising a display panel;
a protective layer (424) configured to protect the display panel; and
one or more joining layers (421, 423, 425, 427, and 428) configured to join the panel layer and the protective layer, and
wherein the bending area is formed as a part of the panel layer and extends and is bent.
